Europäisches Patentamt

European Patent Office

Office européen des brevets

(19)

(11) Veröffentlichungsnummer: **0 129 817**
**B1**

(12) **EUROPÄISCHE PATENTSCHRIFT**

(45) Veröffentlichungstag der Patentschrift:
30.03.88

(51) Int. Cl.⁴: **G 01 R  1/44**, G 01 R  33/06

(21) Anmeldenummer: **84106935.4**

(22) Anmeldetag: **16.06.84**

(54) **Schaltung mit Hall-Generator.**

(30) Priorität: **25.06.83  DE 3322942**

(43) Veröffentlichungstag der Anmeldung:
**02.01.85 Patentblatt 85/1**

(45) Bekanntmachung des Hinweises auf die Patenterteilung:
**30.03.88 Patentblatt 88/13**

(84) Benannte Vertragsstaaten:
**CH FR GB LI**

(56) Entgegenhaltungen:
**EP - A - 0 106 204**
**DD - A - 68 287**
**GB - A - 1 538 915**

**SIEMENS DATENBUCH 1982/83, Siemens AG, München,**
**"Sensoren" "Magnetfeldhalbleiter", Teil 1,**
**(Hallgeneratoren), S. 19-38**

(73) Patentinhaber: **Kernforschungsanlage Jülich**
**Gesellschaft mit beschränkter Haftung, Postfach 1913,**
**D-5170 Jülich 1 (DE)**

(72) Erfinder: **Eulenberg, Hannspeter, Dr., Georgstrasse 33,**
**D-5100 Aachen (DE)**
Erfinder: **Larue, Horst, Athwerk 12, Kerkrade (NL)**

ACTORUM AG

**Beschreibung**

Die Erfindung bezieht sich auf eine Schaltung mit Hall-Generator zur Messung der magnetischen Induktion über die Hall-Spannung, wobei der Hall-Generator einen positiven Temperaturkoeffizienten (TK) des Widerstandes des Steuerstrompfades aufweist, bei der ein mit der Temperatur des elektrischen Systems des Hall-Generators sich ändernder Spannungsanteil eine derartige Änderung des Steuerstromes erzeugt, dass der temperaturbedingte Abfall der Hallspannung kompensiert wird.

Infolge des negativen Temperaturkoeffizienten der Hall-Spannung des Hall-Generators weist dieser eine unerwünschte Temperaturdrift auf.

Aus Siemens Datenbuch 1976/77 «Magnetfeldabhängige Halbleiter» ist eine Schaltung der vorgenannten Art bekannt. Bei dieser bekannten Schaltung wird die Kompensation der Temperaturdrift der Hall-Spannung in einer Brückenschaltung vorgenommen, bei der der Hall-Generator ein Teil der Brücke ist. Abgesehen von den bekannten Nachteilen der Brückenschaltung, hier hinsichtlich der Einkopplung der den Steuerstrom erzeugenden Spannung und der Auskopplung der Signalspannung (Hall-Spannung), ist bei der bekannten Schaltung auch von Nachteil, dass sie keine Unterdrückung anderer Temperatur- und Amplituden-abhängigen Störspannungen ermöglicht.

In der nicht vorveröffentlichten Patentanmeldung EP-A-0 106 204 ist eine Schaltung mit Hallfeldsonde zur Messung der magnetischen Induktion über die Hallspannung beschrieben, bei der jedoch die Hallfeldsonde – anders als bei der vorliegenden Schaltung – einen negativen Temperaturkoeffizienten (TK) des Widerstandes des Steuerstrompfades aufweist. Ziel dieser Schaltung ist die Kompensation der Temperaturdrift der Hallspannung sowie die Möglichkeit, durch weiteren Ausbau weitere, der Hallspannung überlagerte Störspannungen zu kompensieren. Diese Schaltung enthält in dem Steuerstrompfad der Hallfeldsonde einen einstellbaren, praktisch temperaturunabhängigen Vorwiderstand und einen Operationsverstärker, der mit seinem invertierenden Eingang mit einem der Signalspannungskontakte der Feldsonde verbunden ist. Am nichtinvertierenden Eingang des Operationsverstärkers ist gegen Masse eine Gleich- oder Wechselspannung konstanter Amplitude leistungslos eingekoppelt, durch die ein durch die Feldsonde fliessender Steuerstrom erzeugt wird. Die Grösse dieses Steuerstromes ist durch die eingekoppelte Spannung, den Vorwiderstand und den durch die Lage der Signalspannungskontakte bedingten eingangsseitigen Teilwiderstand des Steuerstrompfades der Feldsonde bestimmt.

Es ist Aufgabe der Erfindung, eine Schaltung der eingangs bezeichneten Art (d. h. mit Hallgenerator mit positivem Temperaturkoeffizienten (TK) des Widerstandes des Steuerstrompfades) zu schaffen, die sowohl zu einer Kompensation der Temperaturdrift der Hall-Spannung führt, als auch im weiteren Ausbau eine Kompensation weiterer, der Hall-Spannung überlagerter Störspannungen ermöglicht.

Die der Erfindung zugrunde liegende Aufgabe wird bei einer Schaltung der eingangs bezeichneten Art dadurch gelöst, dass dem Steuerstrompfad des Hall-Generators ein praktisch temperaturunabhängiger Vorwiderstand ($R_1$) vorgeschaltet und ein Operationsverstärker ($OP_1$) mit seinem invertierenden Eingang mit einem der Signalspannungskontakte (2) des Hall-Generators und mit seinem Ausgang mit dem ausgangsseitigen Steuerstromanschluss (1') verbunden ist und an dessen nichtinvertierendem Eingang gegen Masse eine Gleich- oder Wechselspannung ($U_S$ bzw. $u_S$) leistungslos eingekoppelt ist, die aus einem konstanten, den Steuerstrom erzeugenden, temperaturunabhängigen und einem mit der Temperatur des elektrischen Systems des Hall-Generators sich ändernden Spannungsanteil ($U_K$) mittels eines Summierers ($OP_3$) additiv so zusammengesetzt ist, dass bei steigender Temperatur der Steuerstrom durch den Hall-Generator insgesamt so ansteigt, dass der temperaturbedingte Abfall der Hall-Spannung kompensiert wird, wobei der temperaturabhängige Spannungsanteil ($U_K$) mit einem in Operationsverstärkertechnik ausgeführten Differenzverstärker ($D_2$) erzeugt wird, wobei der nichtinvertierende Eingang des Differenzverstärkers mit dem eingangsseitigen Steuerstromanschluss (1) und der invertierende Eingang des Differenzverstärkers mit dem ausgangsseitigen Steuerstromanschluss (1') verbunden ist und wobei der Differenzverstärker so ausgebildet ist, dass die temperaturabhängige Ausgangsspannung ($U_K$) bei einer vorgegebenen Vergleichstemperatur auf Null einstellbar ist.

Wird der Hallgenerator als Feldsonde zur Messung magnetischer Felder eingesetzt, ist die Schaltung gemäss der Erfindung, ohne dass weitere Massnahmen erforderlich wären, bei Messung kleiner magnetischer Wechselfelder mit hinreichender Genauigkeit einsetzbar. Dabei wird zweckmässig als einzukoppelnde Spannung eine Wechselspannung vorgesehen, die vorzugsweise eine höhere Frequenz als das magnetische Wechselfeld aufweist, um die Hall-Spannung frequenzselektiv messen zu können. Auf diese Weise ist die Schaltung gemäss der Erfindung anwendbar, ohne dass beispielsweise eine Kompensation der Ohm'schen Nusspannung erforderlich wäre.

Eine zweckmässige weitere Ausgestaltung der Schaltung gemäss der Erfindung besteht darin, dass zur Unterdrückung der zur Erzeugung des Steuerstromes eingekoppelten Spannung in der zwischen Masse und dem zweiten Signalspannungskontakt der Feldsonde anstehenden Spannung ein in seiner Differenzbildung einstellbarer Differenzverstärker vorgesehen ist, der mit seinem einen Eingang mit dem zweiten Signalspannungskontakt des Hall-Generators und mit seinem zweiten Eingang mit dem ausgangsseitigen Steuerstromanschluss des Hall-Generators und wahlweise mit dem Ausgang des Operationsverstärkers oder mit dessen nicht invertierendem Eingang verbunden ist, wobei die Ausgangsspannung des Differenzverstärkers der temperaturkompensierten Hall-Spannung entspricht. Damit ist der durch die eingekoppelte Spannung bedingte Grundpegel beseitigt, wodurch auch eine hinreichend genaue Messung der Induktion kleiner magnetischer Felder über die Hall-Spannung bei mit Gleichstrom erregten Hall-Generatoren möglich ist.

Das Auftreten der sog. Ohm'schen Nullspannung kann nicht vermieden werden. Diese Nullspannung ist – wenn keine Massnahmen zu ihrer Kompensation vorgesehen werden – der Hallspannung und damit der am Ausgang des Differenzverstärkers anstehenden Spannung überlagert. Eine vorteilhafte Weiterausgestaltung der Schaltung gemäss der Erfindung, bei der ein Differenzverstärker zur Unterdrückung der eingekoppelten Spannung vorgesehen ist, besteht darin, dass zur Kompensation der Nullspannung des Hall-Generators ein zwischen dem ausgangsseitigen Steuerstromanschluss des Hall-Generators und dem Ausgang des Operationsverstärkers liegender, einstellbarer, praktisch temperaturunabhängiger Widerstand vorgesehen ist, wobei der zweite Eingang des Differenzverstärkers mit dem Ausgang des Operationsverstärkers verbunden ist.

Der einstellbare Widerstand beeinflusst nicht die Grösse des Steuerstromes. Es kann dazu benutzt werden, die Grösse einer temperaturabhängigen Spannung einzustellen, die vom Ausgang eines Operationsverstärkers dem zweiten Eingang des Differenzverstärkers zugeführt wird. Durch entsprechende Dimensionierung des einstellbaren Widerstandes wird bei der vorgegebenen Bezugstemperatur die Ohm'sche Nullspannung unterdrückt.

Die Kompensation des temperaturabhängigen Teils der Nullspannung wird durch entsprechende Einstellung des Differenzverstärkers vorgenommen. Für diesen Fall hat sich als zweckmässig erwiesen, dass als Differenzverstärker ein Operationsverstärker mit Trimmer vorgesehen ist, wobei der nicht invertierende Eingang dieses zweiten Operationsverstärkers mit dem zweiten Signalspannungskontakt und der invertierende Eingang mit dem Schleifer des Trimmers verbunden ist und wobei einer der beiden anderen Anschlüsse des Trimmers mit dem Ausgang des zweiten Operationsverstärkers und der weitere Anschluss mit dem Ausgang des ersten Operationsverstärkers verbunden ist. Bei einer bestimmten, durch die Eigenschaften des Hallgenerators vorgegebenen Einstellung des Trimmers wird der Einfluss der Temperatur auf die Ohm'sche Restspannung wesentlich verringert.

Zwischen dem eingangsseitigen Steuerstromanschluss des Hallgenerators und dem mit dem ersten Operationsverstärker in Verbindung stehenden Signalspannungskontakt liegt ein Teil der vom zu messenden Magnetfeld erzeugten Hall-Spannung (bei einem symmetrisch aufgebauten Hall-Generator ist es die halbe Hall-Spannung). Dieser Teil der Hall-Spannung erzeugt einen Steuerstromanteil, der nicht nur durch die Temperatur im Hallgenerator, sondern auch vom zu messenden Magnetfeld beeinflusst wird. Zur Beseitigung dieses störenden Effektes und des an sich vorhandenen Umkehreffektes des Hallgenerators ist eine weitere vorteilhafte Ausführungsform der Schaltung gemäss der Erfindung vorgesehen, die darin besteht, dass zur Kompensation dieses zwischen dem eingangsseitigen Steuerstromanschluss des Hallgenerators und dem mit dem ersten Operationsverstärker in Verbindung stehenden Signalspannungskontakt liegenden Teils der Hall-Spannung und des Umkehreffekts des Hall-Generators einer der Eingänge des Summierers mit dem Ausgang der Schaltung verbunden ist, und an einem weiteren Eingang die einzukoppelnde Spannung anliegt. Über das Summierglied wird gegenphasig zur Hall-Spannung ein Teil der am Ausgang der Schaltung anliegenden Spannung eingekoppelt, womit auch der durch den Umkehreffekt in der Messspannung bedingte Linearitätsfehler der Kennlinie kompensiert wird.

Zur Stabilisierung der Schaltung gegenüber äusseren Temperaturschwankungen hat es sich als äusserst vorteilhaft erwiesen, dass der Vorwiderstand und zwischen dem ausgangsseitigen Steuerstromanschluss des Hall-Generators und dem Ausgang des Operationsverstärkers liegende Widerstand thermisch gekoppelt sind, dass die dem Trimmer vorzuschaltenden Widerstände thermisch gekoppelt sind und dass ausserdem die Steuerstrom führenden Zuleitungsdrähte des Hall-Generators ebenfalls thermisch gekoppelt sind.

Die Schaltung gemäss der Erfindung ermöglicht auch solche Hall-Generatoren für genaue Messungen einzusetzen, die empfindlich sind, aber einen grossen positiven Temperaturkoeffizienten aufweisen.

Verschiedene Ausführungsformen der Schaltung gemäss der Erfindung werden in der Zeichnung dargestellt und im folgenden näher erläutert:
Es zeigen

Figur 1 Schaltung mit Hall-Generator zur Kompensation des temperaturabhängigen Teils der Hall-Spannung,

Figur 2 Schaltung gemäss Figur 1 mit in Operationsverstärkertechnik ausgeführtem Differenzverstärker,

Figur 3 Schaltung mit Hall-Generator gemäss Figur 2 mit Schaltungsteil zur Unterdrückung der eingekoppelten Spannung $u_S$ bzw. $U_S$,

Figur 4 Schaltung mit Hall-Generator gemäss Figur 2 mit Schaltungsteil zur Unterdrückung der Nullspannung und zur Kompensation des temperaturabhängigen Teils der Nullspannung,

Figur 5 Schaltung gemäss Figur 4 mit in Operationsverstärkertechnik ausgeführtem Differenzverstärker und mit Schaltungsteil zur Symmetrierung der Kennlinie des Hall-Generators,

Figur 6 konkrete Ausführungsform der in Figur 5 dargestellten Schaltung.

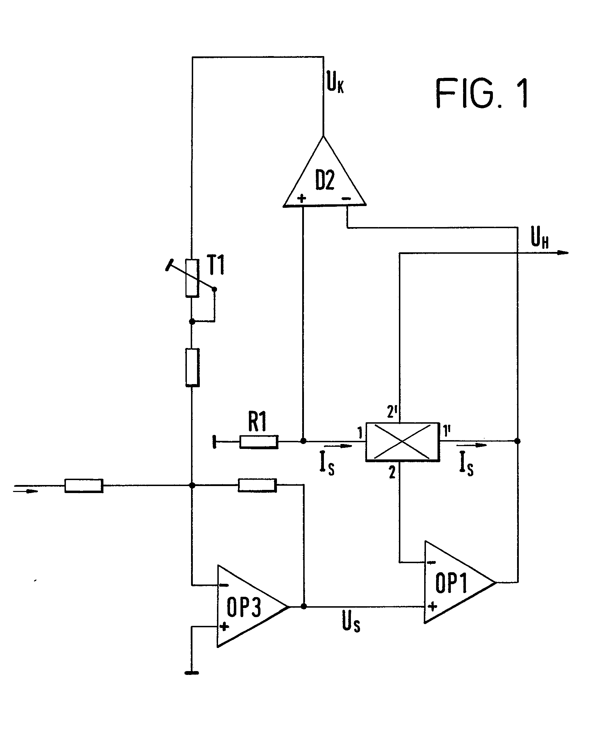

Wie aus Figur 1 hervorgeht, ist dem Steuerstrompfad 1–1' des Hall-Generators der einstellbare Vorwiderstand $R_1$ vorgeschaltet und der Ope-

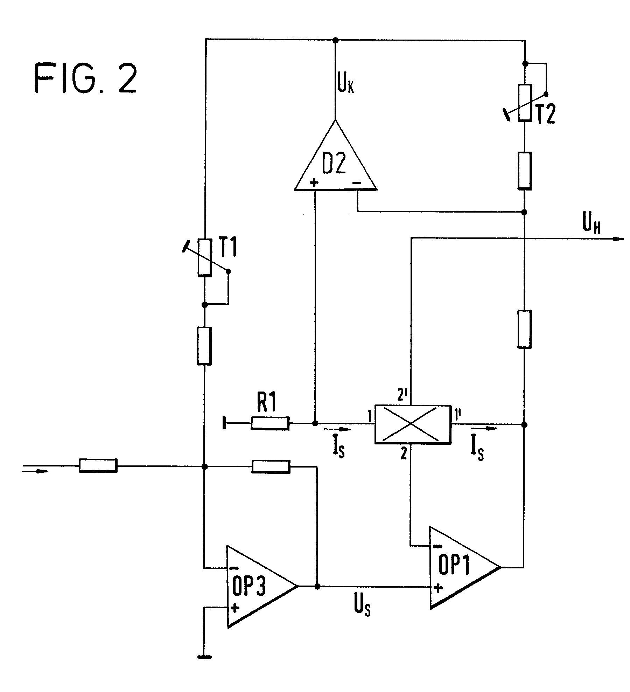

rationsverstärker $OP_1$ mit seinem invertierenden Eingang mit dem Signalspannungskontakt 2 des Hall-Generators und mit seinem Ausgang mit dem ausgangsseitigen Steuerstromanschluss 1′ verbunden. Am nichtinvertierenden Eingang des Operationsverstärkers $OP_1$ ist gegen Masse eine Gleich- oder Wechselspannung $U_S$ (bzw. $u_S$) leistungslos eingekoppelt, die aus einem konstanten temperaturunabhängigen und einem mit der Temperatur des elektrischen Systems des Hall-Generators sich ändernden Spannungsanteil besteht. Der mittels des Trimmers $T_1$ einstellbare, temperaturabhängige Spannungsanteil entsteht aus der Ausgangsspannung $U_k$ des in Operationsverstärkertechnik (wie in Figur 2 dargestellt) ausgeführten Differenzverstärkers $D_2$. Der nichtinvertierende Eingang des Differenzverstärkers ist mit dem eingangsseitigen Steuerstromanschluss 1 und der invertierende Eingang des Differenzverstärkers mit dem ausgangsseitigen Steuerstromanschluss 1′ des Hall-Generators verbunden. Der konstante Spannungsanteil und der sich mit der Temperatur ändernde Spannungsanteil $U_k$ wird mittels des aus Trimmer $T_1$ und Operationsverstärker $OP_3$ bestehenden Summierers additiv so zusammengesetzt, dass der temperaturbedingte Abfall der Hall-Spannung kompensiert wird.

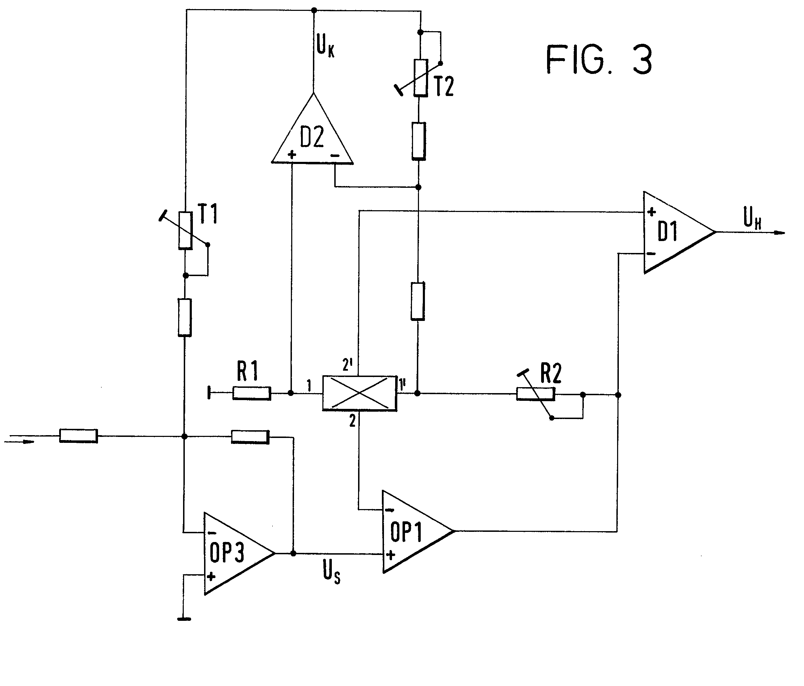

Figur 3 zeigt eine Ausführungsform der Schaltung, in der – ausgehend von der in Figur 2 dargestellten Schaltung – zusätzlich ein in seiner Differenzbildung einstellbarer Differenzverstärker $D_1$ vorgesehen ist. Er dient dazu, die eingekoppelte Spannung $u_S$ in der Ausgangsspannung $u_H$ zu unterdrücken. Der Differenzverstärker $D_1$ ist dazu, wie aus Figur 3 zu ersehen ist, mit einem seiner Eingänge mit dem Ausgang des Operationsverstärkers $OP_1$ verbunden.

In der in Figur 3 dargestellten Ausführungsform der Schaltung ist zusätzlich der einstellbare Widerstand $R_2$ zwischen dem ausgangsseitigen Steuerstromanschluss 1′ des Hall-Generators und dem Ausgang des Operationsverstärkers $OP_1$ vorgesehen. Einer der beiden Eingänge des Differenzverstärkers $D_1$ ist dabei mit dem ausgangsseitigen Anschluss 2′ des Widerstandes $R_2$ und der andere Eingang mit dem Ausgang des Operationsverstärkers $OP_1$ verbunden. Durch entsprechenden Abgleich des Widerstandes $R_2$ wird dem Differenzverstärker $D_1$ eine Spannung zugeführt, mit der die Ausgangsspannung von $D_1$ bei fehlendem Magnetfeld unterdrückt wird. Durch geeignete Einstellung der Differenzbildung in $D_1$ wird bei dieser Schaltungsausführung der temperaturabhängige Teil der Nullspannung kompensiert.

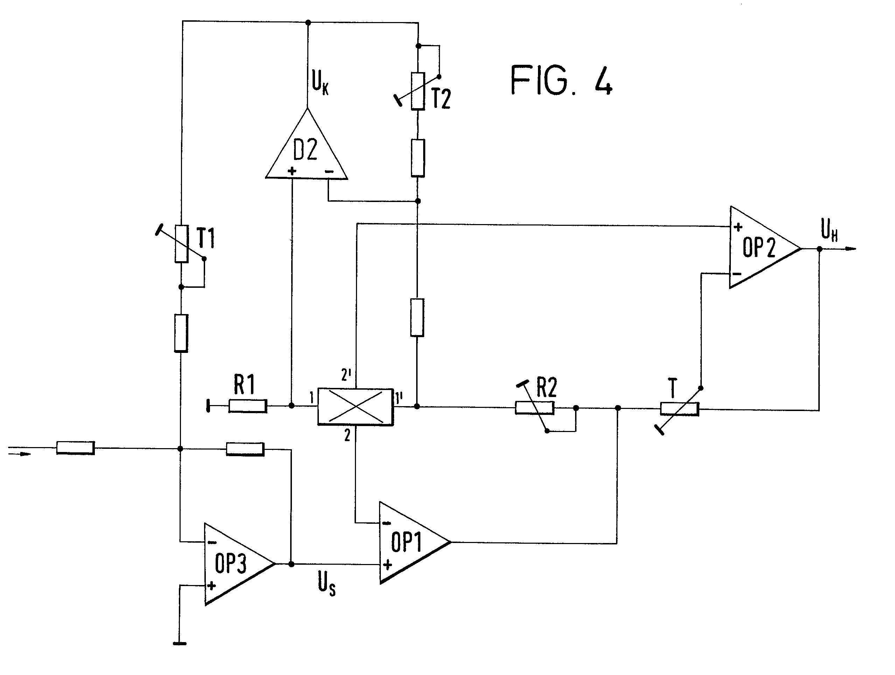

Figur 4 zeigt eine zweckmässige Ausgestaltung des Differenzverstärkers $D_1$ der in Figur 3 dargestellten Schaltungsausführung. Er besteht aus dem Operationsverstärker $OP_2$ und dem vorgeschalteten Trimmer T, der – nach entsprechendem Abgleich von $R_2$ – zur Kompensation des temperaturabhängigen Teils der Nullspannung abgeglichen wird.

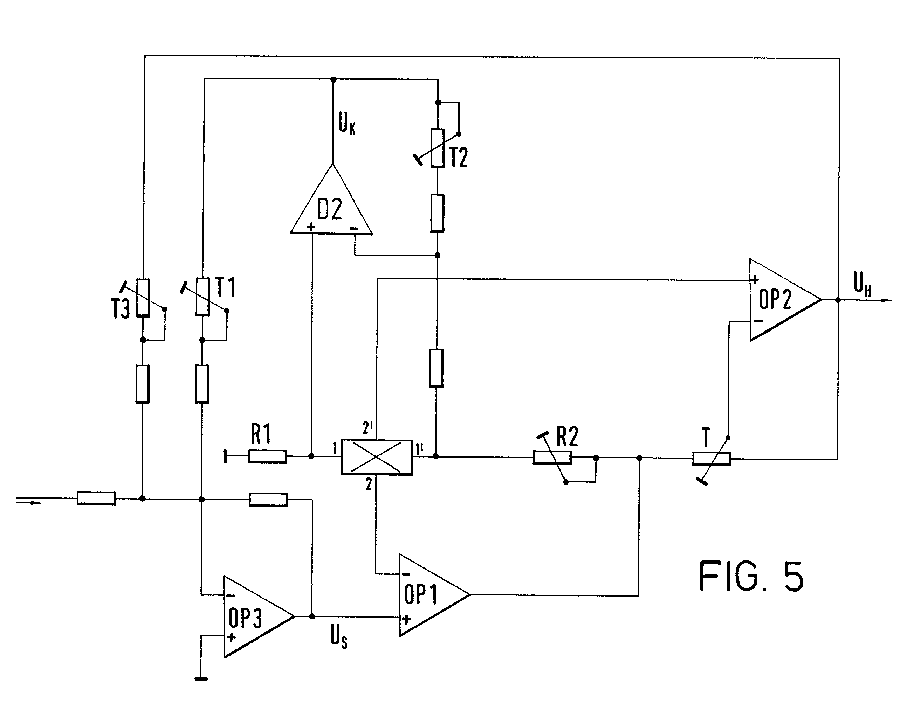

Aus Figur 5 ist ausserdem ein zusätzlicher Schaltungsteil zu ersehen, der zur Kompensation der durch den Umkehreffekt in der Messspannung bedingten Nichtlinearität und insbesondere der Symmetrierung der Kennlinie (Hallspannung in Abhängigkeit von der magnetischen Induktion) dient. Dazu wird ein Teil der Spannung $u_H$, die am Ausgang der Schaltung anliegt, gegenphasig zur Hall-Spannung eingekoppelt. Der entsprechende Abgleich geschieht dabei durch Einstellen des Trimmers $T_3$.

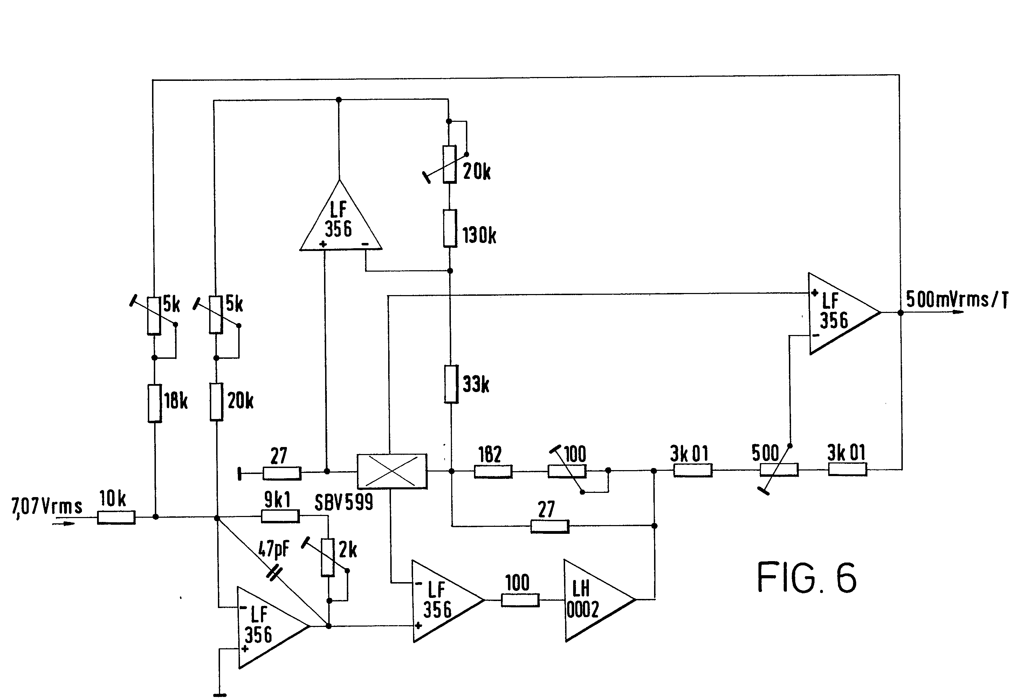

In Figur 6 ist eine konkrete Ausführungsform der in Figur 5 dargestellten Schaltung wiedergegeben. Die Widerstandswerte, die verwendeten Verstärker sowie der verwendete Hall-Generator sind den beigefügten Zahlenangaben bzw. den Typenbezeichnungen zu entnehmen.

**Patentansprüche**

1. Schaltung mit Hall-Generator zur Messung der magnetischen Induktion über die Hall-Spannung, wobei der Hall-Generator einen positiven Temperaturkoeffizienten (TK) des Widerstandes des Steuerstrompfades aufweist, bei der ein mit der Temperatur des elektrischen Systems des Hall-Generators sich ändernder Spannungsanteil eine derartige Änderung des Steuerstromes erzeugt, dass der temperaturbedingte Abfall der Hallspannung kompensiert wird, dadurch gekennzeichnet, dass dem Steuerstrompfad des Hall-Generators ein praktisch temperaturunabhängiger Vorwiderstand ($R_1$) vorgeschaltet und ein Operationsverstärker ($OP_1$) mit seinem invertierenden Eingang mit einem der Signalspannungskontakte (2) des Hall-Generators und mit seinem Ausgang mit dem ausgangsseitigen Steuerstromanschluss (1′) verbunden ist und an dessen nichtinvertierendem Eingang gegen Masse eine Gleich- oder Wechselspannung ($U_S$ bzw. $u_S$) leistungslos eingekoppelt ist, die aus einem konstanten, den Steuerstrom erzeugenden, temperaturunabhängigen und einem mit der Temperatur des elektrischen Systems des Hall-Generators sich ändernden Spannungsanteil mittels eines Summierers ($OP_3$) additiv so zusammengesetzt ist, dass bei steigender Temperatur der Steuerstrom durch den Hall-Generator insgesamt so ansteigt, dass der temperaturbedingte Abfall der Hall-Spannung kompensiert wird, wobei der temperaturabhängige Spannungsanteil mit einem in Operationsverstärkertechnik ausgeführten Differenzverstärker ($D_2$) erzeugt wird, wobei der nichtinvertierende Eingang des Differenzverstärkers mit dem eingangsseitigen Steuerstromanschluss (1) und der invertierende Eingang des Differenzverstärkers mit dem ausgangsseitigen Steuerstromanschluss (1′) verbunden ist und wobei der Differenzverstärker so ausgebildet ist, dass die temperaturabhängige Ausgangsspannung ($U_K$) bei einer vorgegebenen Vergleichstemperatur auf Null einstellbar ist.

2. Schaltung nach Anspruch 1, dadurch gekennzeichnet, dass zur Unterdrückung der zur Erzeugung des Steuerstromes ($i_S$ bzw. $I_S$) eingekoppelten Spannung ($u_S$ bzw. $U_S$) in der zwischen Masse und dem zweiten Signalspannungskontakt (2′) des Hall-Generators anstehenden Spannung ein in seiner Differenzbildung einstellbarer Differenz-

verstärker ($D_1$) vorgesehen ist, der mit seinem einen Eingang mit dem zweiten Signalspannungskontakt (2') des Hall-Generators und mit seinem zweiten Eingang mit dem ausgangsseitigen Steuerstromanschluss (1') des Hall-Generators und wahlweise mit dem Ausgang des Operationsverstärkers ($OP_1$) oder mit dessen nichtinvertierendem Eingang verbunden ist, wobei die Ausgangsspannung des Differenzverstärkers der temperaturkompensierten Hall-Spannung ($u_H$ bzw. $U_H$) entspricht.

3. Schaltung nach Anspruch 2, dadurch gekennzeichnet, dass zur Kompensation der ohmschen Nullspannung des Hall-Generators ein zwischen dem ausgangsseitigen Steuerstromanschluss (1') des Hall-Generators und dem Ausgang des Operationsverstärkers ($OP_1$) liegender, einstellbarer, praktisch temperaturunabhängiger Widerstand ($R_2$) vorgesehen ist, wobei der zweite Eingang des Differenzverstärkers ($D_1$) mit dem Ausgang des Operationsverstärkers ($OP_1$) verbunden ist.

4. Schaltung nach Anspruch 3, dadurch gekennzeichnet, dass als Differenzverstärker ein Operationsverstärker ($OP_2$) mit Trimmer (T) vorgesehen ist, wobei der nichtinvertierende Eingang dieses zweiten Operationsverstärkers mit dem zweiten Signalspannungskontakt (2') und der invertierende Eingang mit dem Schleifer des Trimmers (T) verbunden ist und wobei einer der beiden anderen Anschlüsse des Trimmers mit dem Ausgang des zweiten Operationsverstärkers ($OP_2$) und der weitere Anschluss mit dem Ausgang des ersten Operationsverstärkers ($OP_1$) verbunden ist.

5. Schaltung nach einem der vorhergehenden Ansprüche, dadurch gekennzeichnet, dass zur Kompensation des zwischen dem eingangsseitigen Steuerstromanschluss (1) und dem mit dem ersten Operationsverstärker ($OP_1$) in Verbindung stehenden Signalspannungskontakt (2) liegenden Teils der Hall-Spannung und des Umkehreffektes des Hall-Generators einer der Eingänge des Summierers ($OP_3$) mit dem Ausgang der Schaltung verbunden ist, und an einem weiteren Eingang die einzukoppelnde Spannung ($u_S$ bzw. $U_S$) anliegt.

6. Schaltung nach einem der Ansprüche 3 bis 5, dadurch gekennzeichnet, dass der Vorwiderstand ($R_1$) und der zwischen dem ausgangsseitigen Steuerstromanschluss (1') des Hall-Generators und dem Ausgang des Operationsverstärkers ($OP_1$) liegende Widerstand ($R_2$) thermisch gekoppelt sind.

7. Schaltung nach einem der Ansprüche 4 bis 6, dadurch gekennzeichnet, dass die dem Trimmer (T) vorzuschaltenden Widerstände thermisch gekoppelt sind.

8. Schaltung nach einem der vorhergehenden Ansprüche, dadurch gekennzeichnet, dass die steuerstromführenden Zuleitungsdrähte des Hall-Generators thermisch gekoppelt sind.

## Claims

1. Circuit with a Hall generator for measuring magnetic induction via the Hall voltage, the Hall generator exhibiting a positive temperature coefficient (TC) of resistance of the control current circuit, wherein a voltage value which varies with the temperature of the electric system of the Hall generator produces a change in the control current such that the temperature-caused drop in Hall voltage is compensated, characterised in that a practically temperature-independent series resistor ($R_1$) is connected on the line side of the control current circuit of the Hall generator and an operational amplifier ($OP_1$) is connected by its inverting input to one of the signal voltage contacts (2) of the Hall generator and by its output to the output-side control current terminal (1') and at its non-inverting input a direct or alternating voltage ($U_s$ or $u_s$) is earth-coupled without power output, the voltage having been additively combined by means of a totaliser ($OP_3$) from a constant temperature-independent voltage value generating the control current and a voltage value varying with the temperature of the electric system of the Hall generator, such that as the temperature rises the control current through the Hall generator so rises overall that the temperature-caused drop in Hall voltage is compensated, the temperature-dependent voltage value being generated with a differential amplifier ($D_2$) constructed as in operational amplifier technology, the non-inverting input of the differential amplifier being connected to the input-side control current terminal (1) and the inverting input of the differential amplifier to the output-side control current terminal (1'), and the differential amplifier being so constructed that the temperature-dependent output voltage ($U_k$) is adjustable to zero at a specified reference temperature.

2. Circuit according to Claim 1, characterised in that to suppress the voltage ($u_s$ or $U_s$) coupled to generate the control current ($i_s$ or $I_s$), in the voltage developed between the earth and the second signal voltage contact (2') of the Hall generator a differential amplifier ($D_1$) is provided whose differential formation is adjustable, one of the inputs of said differential amplifier being connected to the second signal voltage contact (2') of the Hall generator and the second input of which is connected to the output-side control current terminal (1') of the Hall generator and, as required, to the output of the operational amplifier ($OP_1$) or the non-inverting input thereof, the output voltage of the differential amplifier corresponding to the temperature-compensated Hall voltage ($u_H$ or $U_H$).

3. Circuit according to Claim 2, characterised in that to compensate ohmic zero voltage from the Hall generator, a variable and practically temperature-independent resistor ($-r_2$) is provided between the output-side control current terminal (1') of the Hall generator and the output of the operational amplifier ($OP_1$), the second input of the differential amplifier ($D_1$) being connected to the output of the operational amplifier ($OP_1$).

4. Circuit according to Claim 3, characterised by providing an operational amplifier ($OP_2$) with a trimmer (T) as the differential amplifier, the non-inverting input of this second operational amplifier being connected to the second signal voltage contact (2') and the inverting input to the slider of the trimmer (T), and one of the two other terminals of the trimmer being connected to the output of the second operational amplifier (OP₂) and the other terminal to the output of the first operational amplifier (OP₁).

5. Circuit according to one of the preceding Claims, characterised in that to compensate that portion of Hall voltage lying between the input-side control current terminal (1) and the signal voltage contact (2) communicating with the first operational amplifier (OP₁), and to compensate the reversing effect of the Hall generator, one of the inputs of the totaliser (OP₃) is connected to the output of the circuit, and the voltage being coupled (u_s or U_s) is applied at a further input.

6. Circuit according to one of Claims 3 to 5, characterised in that the series resistor (R₁) and the resistor (R₂) lying between the output-side control current terminal (1') of the Hall generator and the output of the operational amplifier (OP₁) are thermally coupled.

7. Circuit according to one of Claims 4 to 6, characterised in that the resistors to be connected on the line side of the trimmer (T) are thermally coupled.

8. Circuit according to one of the preceding Claims, characterised in that the Hall generator lead wires carrying the control current are thermally coupled.

**Revendications**

1. Circuit comprenant un générateur à effet Hall pour la mesure de l'induction magnétique par la tension de Hall, le générateur Hall présentant un cœfficient de température positif (TK) de la résistance du trajet du courant de commande, circuit dans lequel une composante de tension qui change avec la température du système électrique du générateur Hall, produit une telle variation du courant de commande que la chute de la tension de Hall sous l'influence de la température est compensée, caractérisé en ce que le trajet du courant de commande du générateur Hall est précédé d'une résistance série (R₁) pratiquement indépendante de la température et un amplificateur opérationnel (OP₁) est relié par son entrée inverseuse à l'un (2) des contacts de tension des signaux du générateur Hall, et par sa sortie à la borne de sortie (1') du courant de commande, et est alimenté à son entrée non inverseuse, par rapport à la masse, par une tension continue ou alternative (U_S ou u_S), sans puissance, tension qui est constituée par addition, au moyen d'un totalisateur (OP₃), d'une composante de tension constante, génératrice du courant de commande et indépendante de la température, et d'une composante de tension variant avec la température du système électrique du générateur Hall, de manière que, en cas d'élévation de la température, le courant de commande parcourant le générateur Hall augmente globalement de telle façon que la chute de la tension de Hall sous l'influence de la température est compensée, la composante de tension variant avec la température étant produite par un amplificateur différentiel (D₂) réalisé selon la technique des amplificateurs opérationnels, l'entrée non inverseuse de l'amplificateur différentiel étant reliée à la borne d'entrée (1) du courant de commande, l'entrée inverseuse de l'amplificateur différentiel étant reliée à la borne de sortie (1') du courant de commande et l'amplificateur différentiel étant réalisé de manière que la tension de sortie (U_K) fonction de la température puisse être réglée à zéro à une température de comparaison préfixée.

2. Circuit selon la revendication 1, caractérisé en ce que, pour supprimer la tension (u_S respectivement U_S) appliquée pour la génération du courant de commande (i_S respectivement I_S) dans la tension appliquée entre la masse et le second contact de tension des signaux (2') du générateur Hall, il comprend un amplificateur différentiel (D₁) qui est réglable dans sa formation de la différence, qui est relié par l'une de ses entrées au second contact de tension des signaux (2') du générateur Hall et par sa seconde entrée à la borne de sortie du courant de commande (1') du générateur Hall, ainsi que, sélectivement, à la sortie de l'amplificateur opérationnel (OP₁) ou à son entrée non inverseuse, la tension de sortie de l'amplificateur différentiel correspondant à la tension de Hall (u_H respectivement U_H) compensée en température.

3. Circuit selon la revendication 2, caractérisé en ce que, pour compenser la tension ohmique nulle du générateur Hall, il comprend une résistance (R₂) réglable, pratiquement indépendante de la température, montée entre la borne de sortie (1') du courant de commande du générateur Hall et la sortie de l'amplificateur opérationnel (OP₁), la seconde entrée de l'amplificateur différentiel (D₁) étant reliée à la sortie de l'amplificateur opérationnel (OP₁).

4. Circuit selon la revendication 3, caractérisé en ce qu'il comprend, en tant qu'amplificateur différentiel, un amplificateur opérationnel (OP₂) avec un potentiomètre (T), l'entrée non inverseuse de ce deuxième amplificateur opérationnel étant reliée au second contact de tension des signaux (2'), son entrée inverseuse étant reliée au curseur du potentiomètre (T), l'une des deux autres bornes du potentiomètre étant reliée à la sortie du deuxième amplificateur opérationnel (OP₂) et l'autre borne étant reliée à la sortie du premier amplificateur opérationnel (OP₁).

5. Circuit selon une des revendications précédentes, caractérisé en ce que, pour compenser la partie de la tension de Hall apparaissant entre la borne d'entrée (1) du courant de commande et le contact de tension des signaux (2), relié au premier amplificateur opérationnel (OP₁), ainsi que pour compenser l'effet d'inversion du générateur Hall, l'une des entrées du totalisateur (OP₃) est reliée à la sortie du circuit et la tension d'alimentation (u_S respectivement U_S) est appliquée à une autre entrée du totalisateur.

6. Circuit selon une des revendications 3 à 5, caractérisé en ce que la résistance série (R₁) et la

résistance ($R_2$) montée entre la borne de sortie (1') du courant de commande du générateur Hall et la sortie de l'amplificateur opérationnel ($OP_1$), sont couplées thermiquement.

7. Circuit selon une des revendications 4 à 6, caractérisé en ce que les résistances à prévoir en amont du potentiomètre (T) sont couplées thermiquement.

8. Circuit selon une des revendications précédentes, caractérisé en ce que les fils de connexion amenant le courant de commande au générateur Hall sont couplés thermiquement.

FIG. 1

FIG. 2

FIG. 3

0 129 817

FIG. 4

FIG. 5

FIG. 6